# EUROPÄISCHE PATENTSCHRIFT

(11) **EP 0 452 301 B1**
(45) Veröffentlichungstag und Bekanntmachung des Hinweises auf die Patenterteilung: **07.04.1993**
(21) Anmeldenummer: 88905767.5
(22) Anmeldetag: 22.06.1988
(51) Int. Cl.: B41M 1/12, B41M 1/30, G03F 7/12, B41M 3/06

(54) **VERFAHREN ZUM HERSTELLEN EINES FLÄCHIGEN STRUKTURMUSTERDRUCKES AUF GLANZOBERFLÄCHEN**
PROCESS FOR PRODUCING A FLAT TEXTURE-PATTERNED PRINT ON SHINY SURFACES
PROCEDE D'IMPRESSION D'UN MOTIF STRUCTURAL PLAN SUR DES SURFACES BRILLANTES

(30) Priorität: 23.06.1987 DE 3720700
(43) Veröffentlichungstag der Anmeldung: 23.10.1991
(73) Patentinhaber: RIEBL, Hannes, D-84076 Pfeffenhausen (DE)
(72) Erfinder: RIEBL, Hannes, D-84076 Pfeffenhausen (DE)
(74) Vertreter: Bauer, Robert, Dipl.-Ing.
(86) Internationale Anmeldenummer: EP8800549
(87) Internationale Veröffentlichungsnummer: WO8810194

(56) Entgegenhaltungen:
- CH-A- 591 959
- FR-A- 1 009 570
- FR-A- 2 093 283
- FR-A- 2 205 006
- FR-A- 2 287 342
- GB-A- 1 056 092
- GB-A- 1 589 280
- GB-A- 2 075 214
- US-A- 3 746 540

## Beschreibung

Die Erfindung betrifft ein Verfahren zur Herstellung eines flächigen Reliefstrukturmusters auf Glanzoberflächen gemäß Gattungsbegriff des Patentanspruchs 1.

Ein derartiges Verfahren, mit dem sich mancherlei neue Gestaltungsmöglichkeiten, insbesondere für das partielle Bedrucken von Klarsichtfolien, eröffnen, ist bereits zur Erzeugung eines Mattdruckes bekannt (Siebdruck-Infopost (SIP) 3, 87, Seite 20). Dabei wird die soweit im normalen Siebdruck flächig bedruckte Folie anschließend, vor der Aushärtung, in einer Stickstoffatmosphäre einer dosierten UV-Licht-Einwirkung unterzogen, wodurch der Lack eine Runzelung erfährt. Die dafür erforderlichen Maschinen sind aufwendig und nur für größere Betriebe erschwinglich.

Zwar ist es auch bereits bekannt, einen Mattdruckeffekt durch Bedrucken einer matten, d.h. rauhen Folie im normalen Siebdruck hervorzurufen, doch können damit keine durchsichtigen Partien erhalten werden. Hier wie dort entzieht sich die Struktur des betreffenden Musters im einzelnen der Einflußnahme durch den Drucker.

Der Erfindung liegt von daher die Aufgabe zugrunde, ein Verfahren nach dem Gattungsbegriff so auszugestalten, daß sich damit auf einfache und kostengünstige Weise Reliefstrukturmuster schlechthin partiell ebenso wie ganzflächig und zudem noch genau reproduzierbar im Siebdruckverfahren drucken lassen.

Diese Aufgabe ist erfindungsgemäß durch die kennzeichnenden Merkmale des Anspruchs 1 gelöst. Die Unteransprüche geben bevorzugte Ausgestaltungsmöglichkeiten an.

Das bereits der Druckschablone eigene Flächenmuster erlaubt es, praktisch jede gewünschte Mattigkeit wie auch andere, z.B. Leinen- oder Holzmaserungsmuster einschließlich des dabei erwarteten Reliefcharakters schon mit dem Druck auf die betreffende Glanzoberfläche aufzubringen.

Aus der Veröffentlichung Hainke "Siebdruck", DuMont Buchverlag Köln 1979, Seite 176 und Abbildungen 88, 89, ist es zwar bereits bekannt, bei der Herstellung einer Siebdruckform eine Vorlage mit z.B. feineren Details wie Strukturen, Linien oder Raster auf den entsprechend beschichteten Schablonenträger (Sieb) unmittelbar aufzubelichten. Ferner sieht die GB-A-1 056 092 die Herstellung eines Marmor- oder Granitmusters unter Anwendung des Siebdruckverfahrens vor. Hier wie dort handelt es sich jedoch lediglich um Flächen-, d.h. zweidimensionale Muster. Daran ändert nichts, daß nach der letztgenannten Literaturstelle schließlich noch diffus entsprechender Gesteinsstaub aufgebracht werden soll.

Einen für den Erhalt reliefartiger Strukturen, hier in Gestalt von durch Blinde ertastbaren Symbolen, in Betracht kommenden Siebdrucklack in Gestalt eines UV-Lackes sieht beispielsweise die DE-A-34 04 723 vor.

Nachfolgend werden Ausführungsbeispiele der Erfindung anhand der Zeichnungen genauer beschrieben.

Die Figuren 1 bis 4 der Zeichnungen zeigen schematisch aufeinanderfolgende Phasen bei der Durchführung des erfindungsgemäßen Verfahrens im Falle einer direkten Photoschablone.

Die Figuren 5 bis 7 zeigen verschiedene dabei als Vorlage verwendbare Musterfolien.

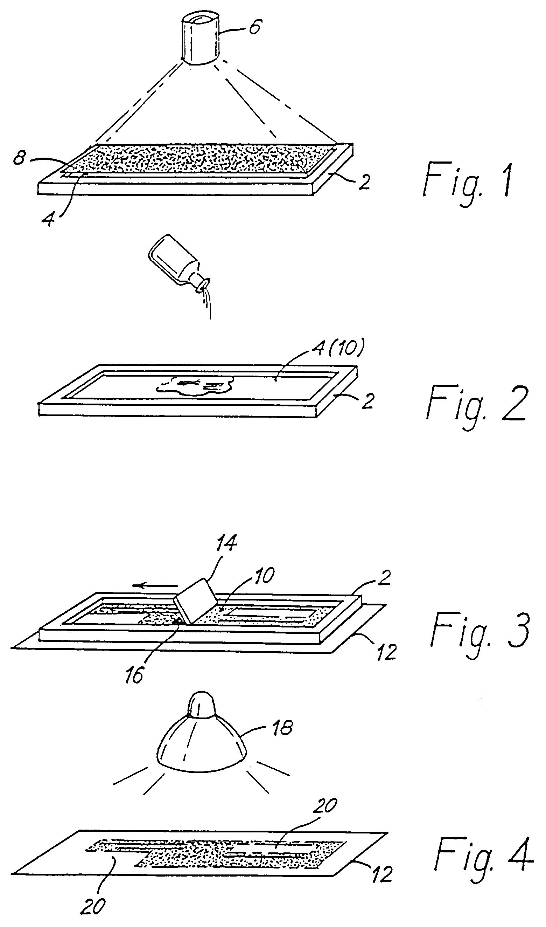

Gemäß Fig. 1 wird auf das in einem Rahmen 2 gehaltene und mit einer lichtempfindlichen Kopierschicht beschichtete Sieb 4 als Schablonenträger über eine Abbildungsoptik 6 die jeweils zu bedruckende Fläche als makroskopisches Muster aufbelichtet. Dabei ist, zum Erhalt des gewünschten, vergleichsweise mikroskopischen Reliefstrukturmusters, unmittelbar über dem beschichteten Sieb 4 - in Wirklichkeit darauf aufliegend - eine Vorlage in Form einer ein Flächenmuster (Abbildung) dieses Reliefstrukturmusters, in diesem Beispiel eines Kornrastermusters, tragenden Klarsicht- oder auch Transparentfolie 8 angeordnet.

Anschließend wird die belichtete Kopierschicht des Siebes 4 entwickelt, wie dies in Fig. 2 angedeutet ist, um die sog. Druckschablone der so erhaltenen Siebdruckform 10 zu ergeben.

Die Siebdruckform 10 wird gemäß Fig. 3 samt Rahmen 2 auf die zu bedruckende Oberfläche, in diesem Fall eine Klarsichtfolie 12, aufgelegt, worauf mittels einer Rakel 14 oder dergl. ein in geläufiger Weise geeignet eingestellter UV-Siebdrucklack 16 aufgestrichen wird. Der Siebdrucklack 16 gelangt an allen nicht durch die Schablone abgedeckten Stellen der Druckform 10 auf die Klarsichtfolie 12, um so das bereits reliefartig strukturierte Druckmuster zu ergeben.

Anschließend wird gemäß Fig. 4 nach Entfernen der Druckform 10 die bedruckte Klarsichtfolie 12 mittels einer UV-Lampe 18 bestrahlt, wodurch der aufgedruckte Siebdrucklack innerhalb kurzer Zeit aushärtet. Dies kann im Gegensatz zu dem eingangs genannten Stand der Technik ohne besondere Hilfsmittel und in normaler Umgebungsluft erfolgen.

Der so im wesentlichen nach dem herkömmlichen Siebdruckverfahren erhaltene Druck weist die gewünschte Mattigkeit auf, während die beim Druck ausgesparten Stellen 20 durchsichtig bleiben.

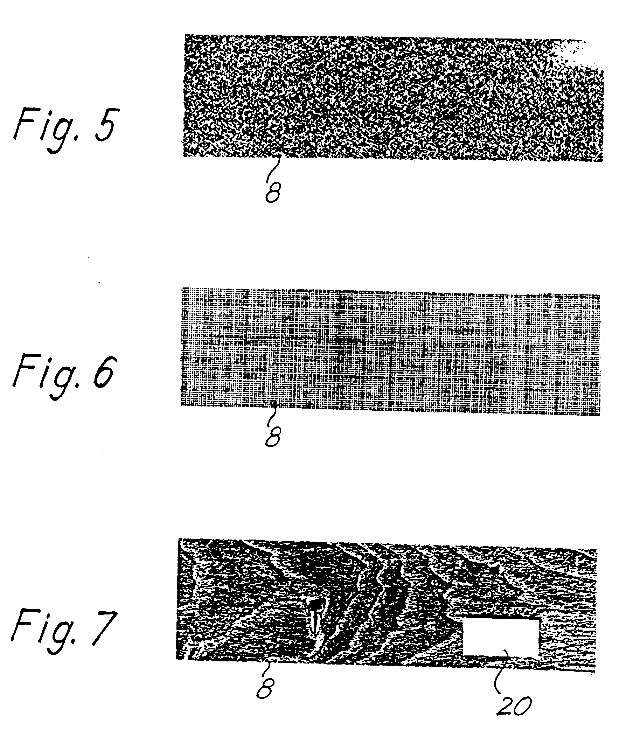

Anstelle eines Kornrastermusters kann die Folie 8 beispielsweise auch das Flächenmuster eines Leinen- oder eines Holzstrukturmusters tragen, wie dies die Figuren 6 und 7 beispielhaft zeigen. Auch können gewünschte Aussparungen 20 oder dergl. bereits in dem Flächenmuster vorgesehen sein (Fig. 7). In diesem Fall erübrigt sich für die Belichtung eine Abbildungsoptik.

## Patentansprüche

1. Verfahren zur Herstellung eines flächigen Reliefstrukturmusters auf Glanzoberflächen, insbes. Klarsichtfolien, unter Anwendung des Siebdrucks, wobei die Druckschablone auf photographischem Wege hergestellt wird, dadurch ***gekennzeichnet***, daß bei der Belichtung des Schablonenträgers (4) auf diesen eine Vorlage in Form einer mit einem Flächenmuster entsprechend dem betreffenden Strukturmuster versehene Klarsicht- oder Transparentfolie (8) aufgelegt wird und daß der Druck mit entsprechend eingestelltem Siebdrucklack (16) von vornherein reliefartig erfolgt und die anschließende Aushärtung des Lackes in beim Siebdruck geläufiger Weise geschieht.

2. Verfahren nach Anspruch 1, dadurch ***gekennzeichnet***, daß als Flächenmuster des Strukturmusters ein solches eines Kornrastermusters, Leinenmusters, Holzmaserungsmusters oder dergl. verwendet wird.

3. Verfahren nach Anspruch 1 oder 2, dadurch ***gekennzeichnet***, daß das Flächenmuster selbst wiederum in Form eines Musters, z.B. mit vorgegebenen Aussparungen (20), auf den Schablonenträger (4) aufbelichtet wird.

4. Verfahren nach einem der vorhergehenden Ansprüche, dadurch ***gekennzeichnet***, daß die Schablone in Gestalt einer direkten Photoschablone unmittelbar auf dem Sieb (4) als Schablonenträger erzeigt wird.

5. Verfahren nach einem der vorhergehenden Ansprüche, dadurch ***gekennzeichnet***, daß als Siebdrucklack (16) ein UV-Lack verwendet und dementsprechend zum Aushärten eine UV-Licht-Bestrahlung vorgenommen wird.

## Claims

1. A process for producing a flat relief-textured pattern on shiny surfaces, especially transparent sheets, using screen printing, the printing stencil being produced photographically, characterized in that when the stencil carrier (4) is illuminated a pattern is laid thereon in the form of a transparent sheet (8) provided with a superficial pattern corresponding to the relevant textured pattern and in that printing with correspondingly adjusted screen printing lacquer (16) is effected in the manner of a relief from the start and the subsequent hardening of the lacquer occurs in a manner usual in screen printing.

2. A process according to claim 1, characterized in that the superficial pattern of the textured pattern is one such as a stipple pattern, a linen pattern, a wood-grain pattern or the like.

3. A process according to claim 1 or claim 2, characterized in that the superficial pattern is itself in turn transmitted onto the stencil carrier (4) in the form of a pattern, e.g. with predetermined recesses (20).

4. A process according to any one of the preceding claims, characterized in that the stencil is produced in the form of a direct photo stencil directly on the screen (4) as stencil carrier.

5. A process according to any one of the preceding claims, characterized in that a UV lacquer is used as screen printing lacquer (16) and UV light radiation is accordingly used for hardening.

## Revendications

1. Procédé d'impression d'un motif structural plan sur des surfaces brillantes, en particulier sur des feuilles transparentes, en employant la sérigraphie, le pochoir d'impression étant réalisé par voie photographique, *caractérisé* en ce que, lors de l'exposition lumineuse du porte-pochoir (4), un dessin-modèle en forme de feuille transparente (8) munie d'un motif plan correspondant au motif structural concerné est placé sur ledit porte-pochoir, et en ce que l'impression s'effectue d'emblée avec un relief au moyen d'une laque de sérigraphie (16) de composition appropriée et le séchage ultérieur de la laque est réalisé de manière classique pour la sérigraphie.

2. Procédé selon la revendication 1, *caractérisé* en ce que, comme motif plan du motif structural, on emploie un motif de trame à grain, de tissu, de veines du bois ou analogue.

3. Procédé selon la revendication 1 ou 2, *caractérisé* en ce que le motif plan proprement dit est, pour sa part, reproduit par exposition lumineuse sur le porte-pochoir (4) sous la forme d'un motif, par exemple avec des réserves (20) prévues.

4. Procédé selon l'une des revendications précédentes, *caractérisé* en ce que le pochoir est réalisé, sous la forme d'un pochoir photographique direct, directement sur l'écran (4) faisant fonction de porte-pochoir.

5. Procédé selon l'une des revendications précédentes, *caractérisé* en ce que la laque de sérigraphie (16) employée est une laque UV et en ce que, par conséquent, une exposition à un rayonnement uv est effectuée pour le séchage.
